# DEMANDE DE BREVET EUROPEEN

(11) **EP 0 949 351 A1**
(43) Date de publication de la demande: **13.10.1999**
(21) Numéro de dépôt: 99400364.8
(22) Date de dépôt: 16.02.1999
(51) Int. Cl.: C23C 16/40, C23C 16/54, C23C 16/44

(54) **Procédé de dépôt de magnésie**

(30) Priorité: 26.03.1998 FR 9803745
(71) Demandeur: Thomson Plasma, 92100 Boulogne-Billancourt (FR)
(72) Inventeur: Baret, Guy, 92100 Boulogne-Billancourt (FR)
(74) Mandataire: Ruellan-Lemonnier, Brigitte

(57) **Abstract**

The present invention relates to a process for depositing a magnesia-based layer on the dielectric surface of a tile of a display panel, consisting in depositing an aerosol on the said dielectric surface by pyrolysis, the said aerosol comprising an organometallic magnesium compound dissolved in a solvent. According to this process, the tile (12) is positioned so that its underside is formed by the dielectric surface, the aerosol being injected (14) towards the underside (12A) of the tile while the top side is heated (13).

The invention applies especially to plasma panels.

## Description

The present invention relates to the manufacture of display panels, especially plasma panels. It relates more particularly to the deposition of a magnesia-based layer on the dielectric surface of a tile forming the said panel. The present invention also relates to an oven for implementing the process.

In general, a plasma panel consists of two tiles formed from a glass substrate, on each of which at least one an array of conducting electrodes covered with a dielectric material is produced. These tiles are joined together in a sealed manner, the arrays of electrodes being approximately orthogonal. The two tiles define a space filled with gas, each intersection of electrodes defining a cell in which discharges in the gas may occur. The dielectric layer which covers the electrodes is an enamel-type layer which isolates the electrodes from the gas and limits the discharge current by storing the charges created by ionization, giving the panel a memory effect. This dielectric layer is generally made of an enamel based on lead oxide, silica and boron oxide (PbO, SiO₂, B₂O₃). The dielectric layer placed on the front tile of the panel, that is to say the face seen by the observer, is generally transparent while that placed on the rear tile is generally white in order to reflect the maximum amount of light forwards. It is conventional to cover the dielectric surface of the tiles with a coating based on magnesia (magnesium oxide MgO) in order to protect it from being bombarded by the ions of the gas, as well as to reduce the voltage necessary for producing a discharge and to guarantee that the voltage necessary for the discharge is stable over time.

To be effective, this magnesia-based coating must have a number of characteristics:
- thus, it must have a high secondary electron emission coefficient,
- be chemically stable enough to not be dissociated under the action of the bombardment by the ions of the gas,
- completely cover the surface of the tile,
- withstand firing at approximately 400°C without undergoing degradation,
- form, with the dielectric layer, an interface which is of uniform appearance, transparent and not electrically conductive.

In order to obtain these characteristics, it is therefore necessary to deposit the magnesia in a dense and crystalline form.

Currently, the magnesia-based coating is deposited by vacuum evaporation of a layer of magnesium oxide a few hundred nanometres in thickness. This operation requires a high-vacuum chamber operating at a pressure of less than or equal to 10⁻⁵ hectopascal. An electron gun is placed in the vacuum chamber. It heats the magnesia, by bombarding it, thereby causing it to evaporate and be deposited on the tile covered with the dielectric. The deposition takes place at a substrate temperature in the region of 100°C. However, the plant used for this deposition is expensive, the cost increasing very quickly with the area of the substrates to be treated. In addition, the duration of the deposition is relatively lengthy because of the necessary thickness, and the production rates may not be high.

To remedy these drawbacks, it has been proposed, in French Patent Application No. 97/07853 dated 24 June 1997 in the name of THOMSON TUBES ELECTRONIQUES, to use an aerosol pyrolysis deposition process. This process consists in creating a mist from an organometallic magnesium compound, such as magnesium acetate or magnesium acetylacetonate dissolved in an organic solvent, such as butanol or methanol, in transferring this mist using a carrier gas, such as air, pure oxygen or a nitrogen/oxygen mixture, to the dielectric surface of the tile, in evaporating the solvent close to the dielectric surface of the tile which is heated to a temperature of between approximately 380°C and 450°C, and in depositing the organometallic compound by pyrolysis, thus giving a magnesia-based coating on the surface of the tile by evaporating the organic radical of the compound. The coating thus formed is impermeable to water.

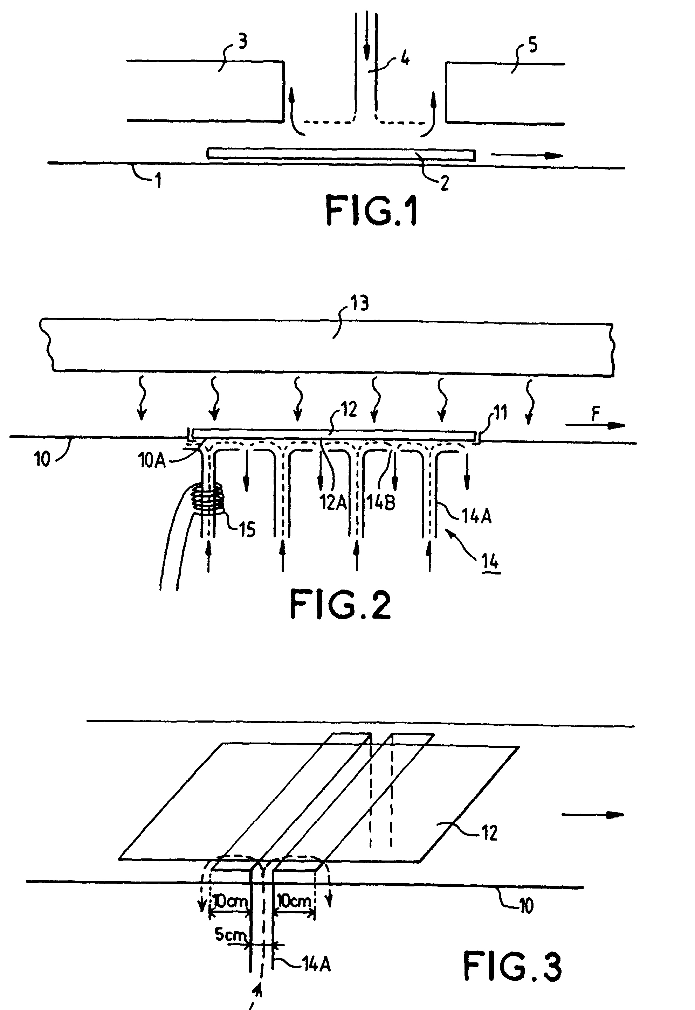

At the present time, in order to carry out the deposition by pyrolysis of an aerosol, ovens of the type shown in Figure 1 are used. The oven shown diagrammatically in Figure 1 is a continuous oven or belt oven, which includes a conveyor 1 on which the substrate 2 to be treated is laid, the treatment face of the substrate being placed uppermost. The deposition itself is carried out after a first heating module 3, using a nozzle 4 which vaporizes the aerosol. Provided between the heating module 3 and the nozzle 4 is a passage for extracting the gases. Another heating module 4 is placed after the nozzle in the direction of movement of the belt. To deposit coatings having a thickness of a few hundred nanometres requires several chambers separated by substrate-heating zones. In this case, the substrate heating and the deposition are not simultaneous.

The apparatus described above has a number of limitations. Since the tile to be treated is placed with its working face on top and with the aerosol being injected from above, the surface will therefore be contaminated by particles inevitably dropping onto it, either coming from the oven itself or from the decomposition of some of the aerosol into the vapour phase before it comes into contact with the surface of the tile. Moreover, since the heating and deposition operations are not carried out simultaneously, this means that there are temperature variations during the deposition. Consequently, the temperature decreases as the tile advances through the deposition chamber. This modification of the temperature results in inevitable deviations in the rate of natural cooling, which in turn gives unevenness in the thickness of the layer deposited and in the width of the tiles treated. In addition, the fact that there is an alternation of the heating modules and of the nozzles leads to an increase in the size of the oven.

The object of the present invention is to propose a deposition process and an oven allowing these drawbacks to be remedied.

Consequently, the subject of the present invention is a process for depositing a magnesia-based layer on the dielectric surface of a tile of a display panel, consisting in depositing an aerosol on the said dielectric surface by pyrolysis, the said aerosol comprising an organometallic magnesium compound dissolved in a solvent, characterized in that the tile is positioned so that its underside is formed by the dielectric surface, the aerosol being injected towards the underside of the tile while the top side is heated.

According to one particular embodiment, the aerosol is injected via an injection system comprising at least one nozzle. Preferably, the injection system comprises several nozzles distributed uniformly over an area corresponding to the dielectric surface to be covered. Preferably, in order to limit the temperatures to which the tile is heated, each nozzle is provided with a heater allowing the aerosol to be preheated, this preheating being carried out between 150 and 250°C.

According to a preferred embodiment, the top side is heated by a heater of the infrared-heating or convection-heating type. This heater raises the tile to a temperature of between 380° and 450°C.

The present invention also relates to an oven for implementing the above process, this oven comprising, in a chamber at atmospheric pressure, a conveyor belt provided with at least one window for accommodating a tile whose dielectric surface faces downwards, a heating means positioned above the conveyor belt and an aerosol injection system placed beneath the conveyor belt. Preferably, the aerosol injection system is connected to a container which contains the solution for the aerosol and is equipped with a droplet generator in order to nebulize the solution, the droplet generator generally being an ultrasonic generator.

Further features and advantages of the present invention will appear on reading a preferred embodiment of an oven, this description being made with reference to the drawings appended herein, in which:
Figure 1, already described, shows diagrammatically an oven for depositing an aerosol by pyrolysis, according to the prior art.
Figure 2 shows diagrammatically an oven for depositing an aerosol by pyrolysis, according to the present invention, and
Figure 3 is a diagrammatic perspective view of a nozzle used in the present invention.
Figure 2 shows diagrammatically an oven according to the present invention. This oven consists of a chamber (not shown) at atmospheric pressure. Provided in this chamber is a conveyor belt (10) which has at least one window (10A) fitted with a support frame (11) for accommodating the tile (12) to be treated. The tile (12) is positioned in such a way that its surface (12A) having the dielectric layer faces downwards, as shown in Figure 2. The belt (10) moves in the direction of the arrow F by any known means. According to the present invention, provided above the belt (10) is a heating module (13). This heating module may consist of infrared heating means or convection heating means. They allow the tile (12) to be heated to a temperature of between 380 and 450°C.

Provided beneath the belt (10) is an aerosol injection system (14). This injection system comprises several nozzles (14A), namely four in the embodiment shown. These nozzles spray the aerosol towards the dielectric surface (12A) of the glass tile, the vapour being extracted via holes (14B). Preferably, and as shown in Figure 2, each nozzle may be provided with a preheating means (15) consisting of a metal wire going around the said nozzle or a heat exchanger in the nozzle. A preheating raises the temperature to approximately 150°C and facilitates the vaporization of the aerosol on the surface (12A) of the tile. The nozzles are arranged over the entire surface of the tile (12), allowing uniform deposition of magnesium oxide (MgO) over the entire dielectric surface. By way of example, Figure 3 shows a specific nozzle with the appropriate dimensions. The nozzle is of rectangular shape, having specifically a width of approximately 5 cm and a length greater than or equal to the width of the tiles. In order to coat the surface (12A) uniformly, the extraction holes must be 10 cm from the said nozzle, on each side, so that the nozzles are separated from each other by approximately 30 to 40 cm.

In a known manner, the injection system (14) is connected to a known apparatus via a pipe, the said apparatus allowing the aerosol to be produced. This apparatus consists of a container which contains a solution formed from an organometallic magnesium compound such as magnesium acetate or magnesium acetylacetonate dissolved in a solvent, preferably an organic solvent such as butanol or methanol. In order to nebulize the solution, the container is equipped with a droplet generator, preferably an ultrasonic generator which is immersed in the solution in the bottom of the container which contains it. Preferably, the solution is maintained at a more or less constant temperature and the container is thermostatted. The use of ultrasonic nebulization gives good homogeneity of the mist forming the aerosol, with droplets more or less of the same size, which in turn results in a coating of more or less uniform thickness. However, other nebulization techniques may be envisaged, especially mechanical techniques.

In a known manner, a carrier gas such as air, pure oxygen or an air/nitrogen mixture is introduced into the top of the container in order to ensure that the aerosol is transported to the dielectric surface of the tile (12).

The use of an oven as described above has a number of advantages. Since the side of the tile to be treated faces downwards, the particles coming from the oven or generated by the decomposition of the aerosol no longer fall on the working surface. Consequently, substrate contamination is greatly reduced. Devices for recovering the powders produced by the vapour-phase reaction, as in the current ovens, need not be provided either. This makes it possible to reduce the length of the deposition chambers and to limit the deposition rate calculated in terms of metres of chamber. Moreover, the heating and deposition operations are carried out in parallel, which in turn allows a constant temperature to be maintained both along the deposition chamber and over the width of this chamber. Consequently, the physical characteristics of the layer are uniform over the entire surface and in the thickness of the layer. With the above system, the overall deposition rate, calculated per unit length of oven, is higher than in the case of the current ovens, thereby allowing a larger number of tiles to be treated.

The present invention has been described with reference to a particular oven, but it is obvious to those skilled in the art that many modifications may be made thereto without departing from the scope of the claims below.

## Claims

1. Process for depositing a magnesia-based layer on the dielectric surface of a tile of a display panel, consisting in depositing an aerosol on the said dielectric surface by pyrolysis, the said aerosol comprising an organometallic magnesium compound dissolved in a solvent, characterized in that the tile is positioned so that its underside is formed by the dielectric surface, the aerosol being injected towards the underside of the tile while the top side is heated.

2. Process according to Claim 1, characterized in that the aerosol is injected via an injection system comprising at least one nozzle.

3. Process according to Claim 2, characterized in that the injection system comprises several nozzles distributed uniformly over an area corresponding to the dielectric surface to be covered.

4. Process according to Claims 2 and 3, characterized in that each nozzle is provided with a heater allowing the aerosol to be preheated.

5. Process according to Claim 4, characterized in that the preheating is carried out between 150 and 200°C.

6. Process according to any one of Claims 1 to 4, characterized in that the top side is heated by a heater of the infrared-heating or convection-heating type.

7. Process according to Claim 6, characterized in that the heater raises the tile to a temperature of between 380° and 450°C.

8. Process according to any one of Claims 1 to 7, characterized in that the organometallic magnesium compound is magnesium acetate or magnesium acetylacetonate.

9. Process according to any one of Claims 1 to 8, characterized in that the solvent is an organic solvent such as butanol or methanol.

10. Process according to any one of Claims 1 to 9, characterized in that the aerosol is transported to the dielectric surface of the tile using a carrier gas such as air, pure oxygen or an air/nitrogen mixture.

11. Oven for implementing the process according to any one of Claims 1 to 10, characterized in that it comprises, in a chamber at atmospheric pressure, a conveyor belt (10) provided with at least one window (10A) for accommodating a tile (12) whose dielectric surface (12A) faces downwards, a heating means (13) positioned above the conveyor belt and an aerosol injection system (14) placed beneath the conveyor belt.

12. Oven according to Claim 11, characterized in that the aerosol injection system is connected to a container which contains the solution for the aerosol and is equipped with a droplet generator in order to nebulize the solution.

13. Oven according to Claim 12, characterized in that the droplet generator is an ultrasonic generator.
